# EUROPÄISCHE PATENTSCHRIFT

(11) **EP 0 402 715 B1**
(45) Veröffentlichungstag und Bekanntmachung des Hinweises auf die Patenterteilung: **06.12.1995**
(21) Anmeldenummer: 90110433.1
(22) Anmeldetag: 01.06.1990
(51) Int. Cl.: H03G 3/04

(54) **Autoradio**
Car radio
Autoradio

(30) Priorität: 14.06.1989 DE 3919428
(43) Veröffentlichungstag der Anmeldung: 19.12.1990
(73) Patentinhaber: Blaupunkt-Werke GmbH, 31132 Hildesheim (DE)
(72) Erfinder: Lauke, Volker, D-3200 Hildesheim (DE); Liman, Helmut, D-3204 Klein Escherde (DE); Attig, Joachim, D-3200 Hildesheim (DE)

(56) Entgegenhaltungen:
- DE-A- 2 950 284
- DE-U- 8 603 945
- PATENT ABSTRACTS OF JAPAN, Band 7, Nr. 76, (E-167), 30. März 1983
- PATENT ABSTRACTS OF JAPAN, Band 13, Nr. 88 (E-721), 28. Februar 1989;

## Beschreibung

Gegenstand des Schutzrechts ist ein Autoradio mit einem Verkehrsfunkdecoder und einer von diesem steuerbaren, mittels eines Tasters schaltbaren Schaltung zur Änderung der Wiedergabelautstärke bei Durchsagen von Verkehrsmeldungen.

Eine Schaltung zur Änderung der Wiedergabelautstärke ist unter anderem aus der DE-AS 21 20 281 bekannt. Zu der vom Oberbegriff her bestimmten Gattung gehört jedes auf dem Markt befindliche Autoradio mit einer Verkehrsfunktaste, z. B. das Gerät "Berlin" der Anmelderin. Nach dem Stand der Technik gemäß der erwähnten Auslegeschrift wird ein die Durchsagelautstärke bestimmender Widerstand im Fußpunkt des Lautstärkereglers bei normalem Empfang einer Sendung durch einen Schalter überbrückt. Der Widerstand wird bei der Fertigung des Gerätes oder bei dem Einbau des Autoradios in ein Fahrzeug fest eingestellt. Im letzteren Fall setzt die Einstellung den Empfang einer Verkehrsdurchsage voraus.

Aus der DE 29 50 284 A1 ist eine Schaltung eines Verkehrsrundfunkdecoders bekannt, bei der die Lautstärke für die Widergabe von Verkehrsmeldungen einstellbar ist. Um auch in Pausen, wenn keine Verkehrsmeldungen gesendet werden, eine Einstellung durchzuführen, wird bei Stummschaltung des Autoradios für eine vorgegebene Zeitdauer ein Durchsagekennungstet durchgeführt. Dazu wird eine Durchsagekennung simuliert, so daß die Lautstärke auf einen gewünschten Pegel eingestellt werden kann. Diese Voreinstellung erfolgt bei der Herstellung oder Wartung des Gerätes und kann vom Fahrer oder Beifahrer eines Fahrzeuges nicht verstellt werden, wenn das Autoradio im Auto eingebaut ist.

Die eingestellte Lautstärke entspricht nicht zu jeder Zeit jedermanns Wunsch. Daher stellte sich die Aufgabe, die Einstellung der Durchsagelautstärke dem Gerätebenutzer zugänglich zu machen, wobei diese Einstellung auch wählbar sein soll, ohne erst das Eintreffen einer Durchsage abwarten zu müssen.

Diese Aufgabe ist mit einem Autoradio lösbar, das die Merkmale des Patentanspruchs 1 aufweist.

Anhand der Zeichnung wird die Erfindung näher erläutert. Darin zeigt

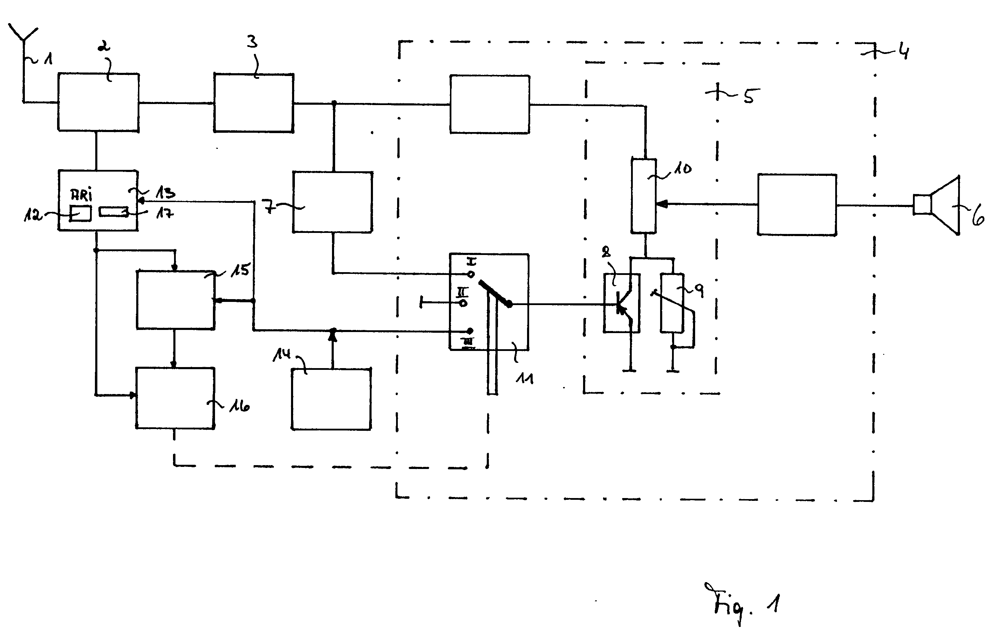

Figur 1 ein teilweise detailliertes Blockschaltbild eines erfindungsgemäßen Autoradios.

Jedes Autoradio ist an einer Antenne 1 angeschlossen, deren Signale in der HF-Stufe 2 verstärkt werden. In der ZF-Stufe 3 wird die NF-Modulation des Senders vom Träger getrennt. Die NF-Modulation selbst wird in der NF-Stufe 4 verstärkt und mit der über den Lautstärkeregler 5 eingestellten Lautstärke vom Lautsprecher 6 wiedergegeben.

Jeder Verkehrsfunkempfänger verfügt außerdem über einen Verkehrsfunkdecoder 7, der parallel zur NF-Stufe 4 an die ZF-Stufe 3 angeschlossen ist. Dieser kann nach dem Stand der Technik eine Schaltung 8 steuern, mit dem ein Widerstand 9 im Fußpunkt des Lautstärkereglers 5 in der Regel überbrückt ist.

In der Regelstellung der Schaltung 8 wird die gewünschte Lautstärke der normalen Sendung oder auch einer Cassettenwiedergabe mit dem Potentiometer 10 im Lautstärkeregler 5 eingestellt. Nicht jedermann wünscht eine Veränderung dieser eingestellten Lautstärke bei einer Verkehrsdurchsage. In diesem Fall kann ein Schalter 11 im Eingang der Schaltung 8 über eine mit ARI (eingetragenes Warenzeichen der Anmelderin) oder eine andere Kennzeichnung bezeichneten Taste 12 im Bedienfeld 13 des Autoradios von der Stellung I in die Stellung II gebracht werden und damit der Verkehrsfunkdecoder ausgeschaltet werden.

Zum Wiedereinschalten des Verkehrsfunkdecoders ist die Taste 12 erneut zu betätigen, wobei der Schalter 11 in die Stellung I zurückfällt.

Empfängt das Autoradio bei einer Verkehrsdurchsage deren Kennung auf dem 57-kHz-Hilfsträger, so wird in der Stellung 1 des Schalters 11 durch den Verkehrsfunkdecoder 7 die Überbrückung des Widerstandes 9 aufgehoben und die Lautstärke der Wiedergabe der Verkehrsdurchsage angehoben.

Manche Autofahrer bevorzugen nur den Empfang von Verkehrsmeldungen mit dem Autoradio und schalten während der Ausstrahlung anderer Sendungen das Autoradio stumm, indem sie das Potentiometer 10 an den unteren Anschlag drehen.

Nicht jedermann gefällt gerade in dieser Betriebssituation die werksseitig eingestellte Durchsagelautstärke, die durch die Aufhebung der Schalterüberbrückung des Widerstandes 9 entsteht. Daher ist zur Lösung der eingangs genannten Aufgabe die bekannte bisher beschriebene Schaltung weiterentwickelt worden.

Der Schalter 11 ist um eine Stellung III erweitert, in der ein Signalgeber 14 an den Eingang des Schalters 11 zur Steuerung der Schaltung 8 angeschlossen ist. Der Schalter 11 erreicht die Stellung III, wenn die Taste 12 eine gewisse Zeitdauer gedrückt bleibt. Die Berührung der Taste 12 löst ein Zeitglied 15 aus. In einer Undschaltung 16 wird geprüft, ob bei Ablauf des Zeitgliedes 15 die Taste 12 noch gedrückt ist.

Hat der Schalter 11 die Stellung III erreicht, dann öffnet der Signalgeber 14 ähnlich wie der Verkehrsfunkdecoder 7 die Schaltung 8 und hebt damit die Überbrückung des Widerstandes 9 auf. Dadurch wird die Lautstärke der momentan vom Lautsprecher wiedergegebenen Sendung oder Cassette angehoben und der Fahrer oder der Beifahrer kann mit dem einstellbaren Widerstand 9, dessen Einstellglied nunmehr selbst am Autoradio zugänglich angeordnet ist, die gewünschte Durchsagelautstärke einstellen.

Hat der Schalter 11 die Stellung III erreicht, dann fällt nach einer weiteren, in dem Zeitglied 15 ausgelösten Zeitdauer der Schalter 11 in die Stellung I zurück.

In aufwendiger aufgebauten Autoradioschaltungen kann die Einstellung des Widerstandes 9 auch über einen Mikroprozessor erfolgen. Mit diesem wird zweckmäßigerweise in der Stellung III des Schalters 11 zugleich die Funktion der Senderwahlwippe 17 im Bedienfeld 13 auf die Funktion der Einstellung des Widerstandes 9 umgeschaltet. Dies hat den Vorteil, daß die Anordnung eines gesonderten Einstellgliedes des Widerstandes 9 an der Gerätefront nicht erforderlich ist.

## Patentansprüche

1. Autoradio mit einem Verkehrsfunkdecoder (7), mit einer von diesem steuerbaren Schaltung (8,9) zur Änderung der Wiedergabelautstärke von Verkehrsmeldungen, wobei ein Taster (12) im Bedienfeld des Autoradios vorgesehen ist,
der einen Schalter (11) bedient, der eine erste, zweite und dritte Schaltstellung besitzt,
wobei der Schalter (11) ausgehend von der ersten Schaltstellung in Abhängigkeit der Dauer der Tasterbetätigung die zweite, beziehungsweise dritte Schalterstellung erreicht,
wobei in der ersten Schaltstellung die steuerbare Schaltung (8, 9) mit dem Verkehrsfunkdekoder verbunden ist und dabei eine Lautstärkenänderung durch den Verkehrsfunkdecoder bei Verkehrsdurchsagen ermöglicht,
und in der zweiten Schaltstellung bewirkt wird, daß bei Verkehrsdurchsagen die Lautstärke nicht geändert wird,
und in der dritten Schaltstellung die steuerbare Schaltung (8,9 ) mit einem Signalgeber (14) verbunden ist,
wobei durch Einschalten der dritten Schaltstellung des Schalters (11) mit einem Einstellglied (9), der Schaltung (8, 9), vorzugsweise einem einstellbaren Widerstand, die Lautstärke von Verkehrsmeldungen einstellbar ist,
**dadurch gekennzeichnet**, daß das Einstellglied (9) auf dem Bedienfeld (13) des Autoradios angeordnet ist,
und daß ein Zeitglied (15) vorgesehen ist, das nach Ablauf einer vorgegebenen Zeitdauer nach Erreichung der dritten Schaltstellung den Schalter (11) in die erste Schaltstellung zurückschaltet.

2. Autoradio nach Anspruch 1,
dadurch gekennzeichnet,
daß in der dritten Schaltstellung der vom Taster (12) bedienbare Schalter (11) die Senderwahlwippe (17) im Bedienfeld (13) über einen Mikroprozessor mit dem Einstellglied der Schaltung (8, 9) zur Änderung der Durchsagelautstärke verbunden ist.

## Claims

1. Car radio with a traffic radio decoder (7), with a circuit (8, 9) which can be controlled thereby in order to change the playback volume of traffic reports, a push button key (12) being provided on the control panel of the car radio, which push button key (12) controls a switch (11) which has a first, second and third switched position,
the switch (11) reaching the second or third switched position starting from the first switched position as a function of the duration of activation of the push button key,
the controllable circuit (8, 9) being connected to the traffic radio decoder in the first switched position and permitting, in the said position, a change in volume by the traffic radio decoder when traffic announcements are made,
and the effect of the second switched position being that the volume is not changed when traffic announcements are made
and the controllable circuit (8, 9) being connected to a signal transmitter (14) in the third switched position, the volume of traffic reports being adjustable with an adjustment element (9) of the circuit (8, 9), preferably an adjustable resistor, by switching on the third switched position of the switch (11),
characterized in that the adjustment element (9) is arranged on the control panel (13) of the car radio, and in that a timing element (15) is provided which switches back the switch (11) into the first switched position after a prescribed time period has passed after the third switched position has been reached.

2. Car radio according to Claim 1, characterized in that, in the third switched position of the switch (11) which can be controlled by the push button key (12), the transmitter selection rocker (17) on the control panel (13) is connected via a microprocessor to the adjustment element of the circuit (8, 9) in order to change the announcement volume.

## Revendications

1. Autoradio à décodeur de message de circulation (7) comprenant un circuit (8, 9) commandé par celui-ci pour modifier l'intensité de reproduction des messages de circulation, une touche (12) étant prévue dans le champ de commande de l'autoradio pour commander un commutateur (11) ayant une première, une seconde, une troisième position de commutation,
le commutateur (11), partant de la première position de commutation, en fonction de la durée d'actionnement de la touche, passe dans la seconde ou troisième position de commutation,
dans la première position de commutation, le circuit commandé (8, 9) est relié au décodeur de messages de circulation et permet ainsi une variation de l'intensité sonore par le décodeur de messages de circulation, au moment de tels messages,
et dans la seconde position de commutation, il fait que les messages de circulation ne modifient pas l'intensité sonore,
et dans la troisième position de commutation, le circuit commandé (8, 9) est relié à un générateur de signal (14),
de sorte qu'en branchant la troisième position de commutation du commutateur (11) à un organe de réglage (9), on règle le circuit (8, 9), de préférence une résistance réglable pour régler l'intensité sonore des messages de circulation,
caractérisé en ce que l'élément de réglage (9) se trouve dans le champ de commande (13) de l'autoradio,
et un élément de temporisation (15) est prévu qui à la fin d'une durée prédéterminée après que l'on soit dans la troisième position du commutateur (11), rebascule dans la première position de commutation.

2. Autoradio selon la revendication 1, caractérisé en ce que dans la troisième position de commutation, le commutateur (11) actionné par la touche (12), relie le balai de sélecteur d'émetteur (17) du champ de commande (13), par un microprocesseur, à l'élément de réglage du circuit (8, 9) pour modifier l'intensité sonore du message.
